# EUROPEAN PATENT APPLICATION

(11) **EP 4 822 047 A1**
(43) Date of publication of application: **14.10.2026**
(21) Application number: 25189201.4
(22) Date of filing: 11.07.2025
(51) Int. Cl.: C22C 1/02, A47J 36/02, C22C 1/04, C22C 19/07, C22C 30/00, C23C 4/08, C23C 14/16, C25D 5/00, C25D 7/00

(54) **LOW SURFACE ENERGY ALLOY MATERIAL, METHOD FOR TREATING A SUBSTRATE PREDETERMINED SURFACE AND A SUBSTRATE PREDETERMINED SURFACE TREATED BY THE METHOD**

(30) Priority: 09.04.2025 CN 202510439040
(71) Applicant: ZHEJIANG JIUKANG ELECTRIC APPLIANCES CO., LTD., Jiaxing Zhejiang 314312 (CN)
(72) Inventor: XU, Jiedong, Jiaxing, 314312 (CN); WANG, Huaqin, Jiaxing, 314312 (CN)
(74) Representative: Gong, Jinping

(57) **Abstract**

A low surface energy alloy material and its use are provided. A composition of the low surface energy alloy material includes at least two of Co, Fe, Ni, Cu, Mn, or Cr, a Co content is within a range of 40-99.9 parts by weight, and each of a Fe content, a Ni content, a Cu content, a Mn content, and a Cr content is within a range of 0.01-20 parts by weight.

## Description

### CROSS-REFERENCE TO RELATED APPLICATIONS

This application claims priority to the Chinese Patent Application No. 202510439040.4, filed on April 9, 2025, the contents of which are hereby incorporated by reference.

### TECHNICAL FIELD

The present disclosure relates to low surface energy alloy materials and the use, and in particular to a low surface energy alloy material and its use.

### BACKGROUND

A Low surface energy material refers to a material with relatively low surface energy, typically characterized by properties such as non-stickiness, easy cleaning, and self-lubrication. A contact angle between the low surface energy material and water exceeds 120°, demonstrating hydrophobic and oleophobic characteristics. The low surface energy material has a lower surface energy due to a fact that surface molecules or structures of the low surface energy material have a weaker adsorption on liquids, which makes it difficult for liquids to spread on the surface of the low surface energy material.

Currently, the low surface energy material mainly includes: a fluorine-containing low surface energy material, a low surface energy drag-reducing coating, and an antifouling coating. The fluorine-containing low surface energy material reduces a surface energy by introducing fluorine atoms into polymer chains. For example, polytetrafluoroethylene (PTFE) has the surface energy of approximately 20 mN/m. The low surface energy drag-reducing coating is primarily used for hydrophobic drag reduction and coating-based drag reduction, achieving resistance reduction by minimizing fluid shear stress on wall surfaces. The antifouling coating utilizes the properties of the low surface energy material to prevent fouling from adhering to the surface of the antifouling coating, which is suitable for ships, marine engineering, and other fields.

The low surface energy material has a wide range of applications in a plurality of fields. In marine engineering, such as docks, bridges, and offshore platforms, the low surface energy material prevents marine organisms from adhesion, thereby reducing frictional resistance. In shipbuilding, the low surface energy material minimizes sailing resistance, inhibits fouling adhesion, and improves navigation efficiency. In winter sports, the low surface energy material may be applied to equipment such as skis and ice skates to reduce friction and enhance athletic performance.

A preparation process of the low surface energy material typically involves components such as fluorinated resins, epoxy resins, and composite curing agents, offering an excellent weather resistance, a lubricity, and an environmental friendliness, with promising market prospects. With a development of the marine engineering and the shipbuilding industry, a demand for the low surface energy material continues to grow annually, indicating significant market potential.

Although the low surface energy material exhibits superior performance in many fields, the low surface energy material may face challenges such as an insufficient thermal resistance, a limited mechanical strength, a susceptibility to wear, and a suboptimal chemical stability under certain conditions during prolonged use. For example, the properties may degrade under a high temperature, high pressure, or high corrosive environment. Currently, a low surface energy alloy material has not yet been disclosed. Moreover, an alloy layer is non-toxic to human health, is chemically stable, and possesses better temperature resistance, providing a new approach to developing the low surface energy alloy material.

Therefore, there is a need to provide a low surface energy alloy material and its use. By treating a substrate predetermined surface, the substrate predetermined surface is endowed with low surface energy properties while retaining the alloy material's excellent mechanical performance and chemical stability, thereby enhancing the substrate's overall performance and service life.

### SUMMARY

To address the aforementioned issues, the present disclosure aims to provide a low surface energy alloy material and its use, wherein an alloy layer comprises a distribution of nano/micro-structured concave holes. The low surface energy alloy material is treated via a low-cost surface engineering technique to obtain the alloy layer. The alloy layer is applicable in a plurality of fields, including but not limited to non-stickiness cookware and other cookware, marine engineering equipment, a ship component, and ice/snow sports equipment.

To achieve the above objective, some embodiments of the present disclosure provide a low surface energy alloy material, a composition of the low surface energy alloy material comprises at least two of Co, Fe, Ni, Cu, Mn, or Cr, a Co content is within a range of 40-99.9 parts by weight, and each of a Fe content, a Ni content, a Cu content, a Mn content, and a Cr content is within a range of 0.01-20 parts by weight.

### BRIEF DESCRIPTION OF THE DRAWINGS

The present disclosure will be further illustrated by way of exemplary embodiments, which will be described in detail through the accompanying drawings. These embodiments are not limiting, and in these embodiments, the same numbering denotes the same structure, wherein:
FIG. 1 is a schematic diagram illustrating arrangement and distribution of rectangular concave holes in a cookware according to some embodiments of the present disclosure;
FIG. 2 is a schematic diagram illustrating arrangement and distribution of hexagonal concave holes in a cookware according to some embodiments of the present disclosure; and
FIG. 3 is a scanning electron microscope (SEM) image of a cookware according to some embodiments of the present disclosure.

### DETAILED DESCRIPTION

The present disclosure is further described below in conjunction with the accompanying drawings. Embodiments of the present disclosure are described in detail, and examples of the embodiments are illustrated in the accompanying drawings, and the same or similar symbols throughout indicate the same objects.

In some embodiments, a composition of a low surface energy alloy material comprises at least two of Co, Fe, Ni, Cu, Mn, or Cr, a Co content is within a range of 40-99.9 parts by weight, and each of a Fe content, a Ni content, a Cu content, a Mn content, and a Cr content is within a range of 0.01-20 parts by weight.

The low surface energy alloy material refers to a metallic material with low surface energy properties formed through an alloying material and a preparation process.

In some embodiments, the composition of the low surface energy alloy material includes Co, Fe, Ni, Cu, Mn, Cr, etc. In some embodiments, the composition of the low surface energy alloy material may also be set according to practical needs. More descriptions regarding the composition of the low surface energy alloy material may be found in the following and related descriptions.

In some embodiments, weight parts corresponding to different compositions of the low surface energy alloy material may be set according to practical needs.

In some embodiments, the Co content is within a range of 40-99.9 parts by weight. In some embodiments, the Co content is within a range of 40-50 parts by weight, a range of 50-58 parts by weight, a range of 58-62 parts by weight, a range of 62-69 parts by weight, a range of 69-75 parts by weight, a range of 75-80 parts by weight, a range of 80-85 parts by weight, a range of 85-89 parts by weight, a range of 89-90 parts by weight, a range of 90-93 parts by weight, a range of 93-95 parts by weight, a range of 95-96 parts by weight, a range of 96-98 parts by weight, a range of 98-99.9 parts by weight, etc. For example, the Co content may be 40 parts by weight, 50 parts by weight, 58 parts by weight, 62 parts by weight, 69 parts by weight, 75 parts by weight, 80 parts by weight, 85 parts by weight, 89 parts by weight, 90 parts by weight, 93 parts by weight, 95 parts by weight, 96 parts by weight, 98 parts by weight, 99.9 parts by weight, etc. More descriptions regarding the Co content may be found in the following and related descriptions.

In some embodiments, the Fe content is within a range of 0.01-20 parts by weight. In some embodiments, the Fe content is also within a range of 0.01-15 parts by weight. In some embodiments, the Fe content is also within a range of 0.01-0.1 parts by weight. In some embodiments, the Fe content is also within a range of 0.5-15 parts by weight. In some embodiments, the Fe content is also within a range of 0.4-5 parts by weight. In some embodiments, the Fe content is also within a range of 0.5-4 parts by weight. For example, the Fe content may be within a range of 0.5-2 parts by weight, a range of 2-2.5 parts by weight, a range of 2.5-4 parts by weight, a range of 4-5 parts by weight, etc. For example, the Fe content may be 0.01 parts by weight, 0.5 parts by weight, 2 parts by weight, 2.5 parts by weight, 4 parts by weight, 5 parts by weight, 15 parts by weight, 20 parts by weight, etc.

In some embodiments, the Ni content is within a range of 0.01-20 parts by weight. In some embodiments, the Ni content is also within a range of 0.01-15 parts by weight. In some embodiments, the Ni content is also within a range of 0.01-1 parts by weight. In some embodiments, the Ni content is also within a range of 0.1-0.5 parts by weight. In some embodiments, the Ni content is also within a range of 0.5-8 parts by weight. In some embodiments, the Ni content may be within a range of 0.5-1 parts by weight, a range of 1-2 parts by weight, a range of 2-3 parts by weight, a range of 3-4 parts by weight, a range of 4-5 parts by weight, a range of 5-8 parts by weight, etc. For example, the Ni content may be 0.01 parts by weight, 0.5 parts by weight, 1 part by weight, 2 parts by weight, 3 parts by weight, 4 parts by weight, 5 parts by weight, 8 parts by weight, 15 parts by weight, 20 parts by weight, etc. More descriptions regarding the Ni content may be found in the following and related descriptions.

In some embodiments, the Cu content is within a range of 0.01-20 parts by weight. In some embodiments, the Cu content is also within a range of 0.01-15 parts by weight. In some embodiments, the Cu content is also within a range of 0.01-0.1 parts by weight. For example, the Cu content may be within a range of 0.01 parts by weight, 0.1 parts by weight, 10 parts by weight, 15 parts by weight, 20 parts by weight, etc.

In some embodiments, the Mn content is within a range of 0.01-20 parts by weight. In some embodiments, the Mn content is also within a range of 0.01-15 parts by weight. In some embodiments, the Mn content is also within a range of 0.01-0.1 parts by weight. In some embodiments, the Mn content is also within a range of 0.5-5 parts by weight. In some embodiments, the Mn content may be within a range of 0.5-2 parts by weight, a range of 2-4 parts by weight, a range of 4-5 parts by weight, etc. For example, the Mn content may be 0.01 parts by weight, 0.1 parts by weight, 0.5 parts by weight, 2 parts by weight, 4 parts by weight, 5 parts by weight, 15 parts by weight, 20 parts by weight, etc. More descriptions regarding the composition of the low surface energy may be found in the following and related descriptions.

In some embodiments, the Cr content is within a range of 0.01-20 parts by weight. In some embodiments, the Cr content is also within a range of 0.01-15 parts by weight. In some embodiments, the Cr content is also within a range of 0.01-0.1 parts by weight. In some embodiments, the Cr content is also within a range of 0.01-0.5 parts by weight. In some embodiments, the Cr content is also within a range of 1-20 parts by weight. In some embodiments, the Cr content may be within a range of 1-2 parts by weight, a range of 2-3 parts by weight, a range of 3-4 parts by weight, a range of 4-5 parts by weight, a range of 5-7 parts by weight, a range of 7-8 parts by weight, a range of 8-12 parts by weight, a range of 12-14 parts by weight, a range of 14-15 parts by weight, a range of 15-17 parts by weight, a range of 17-18 parts by weight, a range of 18-20 parts by weight, etc. For example, the Cr content may be 0.01 parts by weight, 1 part by weight, 2 parts by weight, 3 parts by weight, 4 parts by weight, 5 parts by weight, 7 parts by weight, 8 parts by weight, 12 parts by weight, 14 parts by weight, 15 parts by weight, 17 parts by weight, 18 parts by weight, 20 parts by weight, etc. More descriptions regarding the Cr content may be found in the following and related descriptions.

In some embodiments, the composition of the low surface energy alloy material further includes Mo.

In some embodiments, the Cr content is within a range of 0.5-8 parts by weight, and a Mo content is within a range of 0.5-8 parts by weight.

In some embodiments, the Cr content is also within a range of 1-8 parts by weight. For example, the Cr content may be 1 part by weight, 2 parts by weight, 3 parts by weight, 4 parts by weight, 5 parts by weight, 7 parts by weight, 8 parts by weight, etc.

In some embodiments, the Mo content is also within a range of 2-8 parts by weight. In some embodiments, the Mo content may be within a range of 2-3 parts by weight, a range of 3-4 parts by weight, a range of 4-5 parts by weight, a range of 5-6 parts by weight, a range of 6-8 parts by weight, etc. For example, the Mo content may be 2 parts by weight, 3 parts by weight, 4 parts by weight, 5 parts by weight, 6 parts by weight, 8 parts by weight, etc.

By setting the Cr content within the range of 0.5-8 parts, it ensures corrosion resistance of the low surface energy alloy material and cost savings. Additionally, by introducing 0.5-8 parts by weight of the Mo, it enhances a corrosion resistance, a strength, and a toughness of the low surface energy alloy material.

In some embodiments, the Co content is within a range of 85-99.9 parts by weight, the Cr content is within a range of 0.1-15 parts by weight, the Mo content is within a range of 0.5-5 parts by weight, and the Ni content is within a range of 0.5-5 parts by weight.

In some embodiments, the Co content may be within a range of 85-89 parts by weight, a range of 89-90 parts by weight, a range of 90-93 parts by weight, a range of 93-95 parts by weight, a range of 95-96 parts by weight, a range of 96-99.9 parts by weight, etc. For example, the Co content may be 85 parts by weight, 89 parts by weight, 90 parts by weight, 93 parts by weight, 95 parts by weight, 96 parts by weight, 99.9 parts by weight, etc.

In some embodiments, the Cr content is also within a range of 1-15 parts by weight. In some embodiments, the Cr content may be within a range of 1-2 parts by weight, a range of 2-3 parts by weight, a range of 3-4 parts by weight, a range of 4-5 parts by weight, a range of 5-7 parts by weight, a range of 7-8 parts by weight, a range of 8-12 parts by weight, a range of 12-14 parts by weight, a range of 14-15 parts by weight, etc. For example, the Cr content may be 0.1 parts by weight, 1 part by weight, 2 parts by weight, 3 parts by weight, 4 parts by weight, 5 parts by weight, 7 parts by weight, 8 parts by weight, 12 parts by weight, 14 parts by weight, 15 parts by weight, etc.

In some embodiments, the Mo content is also within a range of 2-5 parts by weight. In some embodiments, the Mo content may be within a range of 2-3 parts by weight, a range of 3-4 parts by weight, a range of 4-5 parts by weight, etc. For example, the Mo content may be 2 parts by weight, 3 parts by weight, 4 parts by weight, 5 parts by weight, etc.

In some embodiments, the Ni content may be within a range of 0.5-1 part by weight, a range of 1-2 parts by weight, a range of 2-3 parts by weight, a range of 3-4 parts by weight, a range of 4-5 parts by weight, etc. For example, the Ni content may be 0.5 parts by weight, 1 part by weight, 2 parts by weight, 3 parts by weight, 4 parts by weight, 5 parts by weight, etc.

By increasing the Co content to be within the range of 85-99.9 parts by weight, it ensures a stability and a low surface energy of the low surface energy alloy material. By optimizing the ratios of the Cr (0.1-15 parts by weight), the Mo (0.5-5 parts by weight), and the Ni (0.5-5 parts by weight), it can help to enhance a comprehensive performance of the low surface energy alloy material.

In some embodiments, the composition of the low surface energy alloy material further includes Ti and Si.

In some embodiments, at least one of a Ti content and a Si content is within a range of 0.5-15 parts by weight.

In some embodiments, the Ti content is within a range of 0.5-15 parts by weight. In some embodiments, the Ti content is also within a range of 1-5 parts by weight. In some embodiments, the Ti content may be within a range of 1-2 parts by weight, a range of 2-4 parts by weight, a range of 4-5 parts by weight, etc. For example, the Ti content may be 0.5 parts by weight, 1 part by weight, 2 parts by weight, 4 parts by weight, 5 parts by weight, 15 parts by weight, etc.

In some embodiments, the Si content is also within a range of 0.8-1 parts by weight. For example, the Si content may be 0.5 parts by weight, 0.8 parts by weight, 1 part by weight, 15 parts by weight, etc.

An addition of the Ti contributes to improving a high temperature resistance and a strength of the low surface energy alloy material while enhancing a coating adhesion. An addition of Si helps to improve a fluidity and an oxidation resistance of the low surface energy alloy material, facilitating formation of a denser surface structure.

In some embodiments, the composition of the low surface energy alloy material further includes the Ti and the Mo. The Co content is within a range of 40-80 parts by weight, the Cr content is within a range of 7-20 parts by weight, the Mo content is not greater than 8 parts by weight, the Ni content is within a range of 1-8 parts by weight, and at least one of the Mn content and the Ti content is within a range of 0.5-15 parts by weight. In some embodiments, the Co content may be within a range of 40-50 parts by weight, a range of 50-58 parts by weight, a range of 58-62 parts by weight, a range of 62-69 parts by weight, a range of 69-75 parts by weight, a range of 75-80 parts by weight, etc. For example, the Co content may be 40 parts by weight, 50 parts by weight, 58 parts by weight, 62 parts by weight, 69 parts by weight, 75 parts by weight, 80 parts by weight, etc.

In some embodiments, the Cr content may be within a range of 7-14 parts by weight, a range of 14-20 parts by weight, etc. For example, the Cr content may be 7 parts by weight, 15 parts by weight, 20 parts by weight, etc. The Mo content may be 0.5 parts by weight, 5 parts by weight, 8 parts by weight, etc. The Ni content may be 1 part by weight, 4 parts by weight, 8 parts by weight, etc. The Mn content may be 0.5 parts by weight, 7 parts by weight, 15 parts by weight, etc. The Ti content may be 0.5 parts by weight, 7 parts by weight, 15 parts by weight, etc.

By adjusting the Co content to be within the range of 40-80 parts by weight, it ensures the low surface energy properties of the low surface energy alloy material. By increasing the Cr content to be within the range of 7-20 parts by weight, it can enhance the corrosion resistance of the low surface energy alloy material. By controlling the Mo content to be not greater than 8 parts by weight and the Ni content to be within the range of 1-8 parts by weight, it can improve the high temperature strength and the toughness of the low surface energy alloy material. By adding 0.5-15 parts by weight of Mn and/or Ti, it improves the machinability and the high temperature oxidation resistance of the low surface energy alloy material.

By controlling the Co content to be within the range of 40-99.9 parts by weight, the low surface energy alloy material is endowed with stable low surface energy properties and possesses good hydrophobicity and oleophobicity as well as anti-adhesion properties. Combined with the addition of 0.01-20 parts by weight of Fe, Ni, Cu, Mn, and Cr, a mechanical strength and the corrosion resistance of the low surface energy alloy material are optimized.

In the fields such as a marine engineering, a ship building, ice/snow sports, and cookware, there exists an urgent demand for material surface properties such as non-stickiness properties, easy cleaning performance and corrosion resistance. Currently, although surface coating or modification technologies can improve material surface performance, these manners often suffer from insufficient temperature resistance, inadequate mechanical strength and susceptibility to wear.

Therefore, by fabricating the low surface energy alloy material into an alloy layer and disposing the alloy layer on a substrate predetermined surface, it not only fully utilizes excellent surface properties of the low surface energy alloy material, but also addresses economic and processing challenges.

In some embodiments, a method for treating the substrate predetermined surface includes: forming the alloy layer on the substrate predetermined surface by applying the low surface energy alloy material onto the substrate predetermined surface via electroplating deposition, physical vapor deposition (PVD), plasma spraying, or supersonic spraying.

A substrate refers to an underlying device or component that serves as a supporting structure.

The substrate predetermined surface refers to a location in the substrate where the alloy layer is to be formed. In some embodiments, the substrate predetermined surface includes at least one of a predetermined surface of marine engineering equipment, a predetermined surface of a ship component, a predetermined surface of ice/snow sports equipment, a predetermined surface of cookware.

A predetermined surface refers to a location that requires to have properties such as anti-corrosion and non-stickiness. For example, the predetermined surface of the marine engineering equipment includes a hull, a propeller, and other parts that are in contact with seawater. The predetermined surface of the ship component includes a hull structure, a propulsion device, etc. The predetermined surface of the ice/snow sports equipment includes a ski, a skate blade, and other parts that are in direct contact with ice and snow. The predetermined surface of the cookware includes food-contact areas, such as an inner surface of the pot body, an inner surface pf the pot lid, etc.

The alloy layer refers to a functional covering layer formed on the substrate predetermined surface.

In some embodiments, a thickness of the alloy layer is within a range of 0.2 µm-500 µm. In some embodiments, the thickness of the alloy layer may be within a range of 0.2 µm-250 µm, a range of 250 µm-500 µm, etc. For example, the thickness of the alloy layer may be 0.2 µm, 250 µm, 500 µm, etc. The thickness of the alloy layer may also be set according to practical needs.

In some embodiments, the alloy layer is formed on the substrate predetermined surface by applying the low surface energy alloy material onto the substrate predetermined surface in a plurality of ways.

In some embodiments, the alloy layer is formed on the substrate predetermined surface by applying the low surface energy alloy material onto the substrate predetermined surface via the electroplating deposition, the PVD, the plasma spraying, or the supersonic spraying.

For example, the electroplating deposition (also referred to as coating coverage) includes: utilizing an electrolytic principle, immersing the low surface energy alloy material serving as an anode and a substrate to be plated as a cathode in an electrolyte solution containing alloy ions, under the action of a direct current electric field, alloy ions migrating toward the cathode and undergoing reduction deposition on the substrate predetermined surface, progressively forming the alloy layer.

As another example, the PVD includes: in a vacuum environment, converting solid/liquid material into vapor phase through physical method such as evaporation, sputtering, or ionization, followed by depositing onto the substrate predetermined surface to form a micron scale thin film.

In some embodiments, the PVD includes vacuum evaporation coating, vacuum sputtering coating, and vacuum ion coating. The vacuum evaporation coating includes heating the target material for evaporative and deposition, etc., and the vacuum sputtering coating includes ion bombardment of the target material for sputtering particles, etc.

The vacuum evaporation coating includes: heating an alloy target material through an electron beam, an electrical resistance, an arc, a laser, etc., so as to cause the alloy target material to evaporate and to condense on the substrate predetermined surface into the alloy layer.

The vacuum sputtering coating (such as a magnetron sputtering) includes: utilizing direct current (DC), radio frequency (RF), or magnetron sputtering technology to bombard a target material with ions or high-energy particles, and the ions or high-energy particles are then sputtered and deposited onto the substrate predetermined surface to form a high-density and high-adhesion alloy layer.

The vacuum ion coating (such as a multi-arc ion plating) includes: ionizing the target material through arc discharge to form an alloy layer with optimal bonding strength and hardness. For example, the alloy layer exhibits superior mechanical properties including high coating hardness and strong wear resistance (with a friction coefficient as low as 0.2), along with corrosion resistance surpassing conventional electroplating manners, absence of heavy metal contamination, and excellent chemical stability. In this manner, the thickness of the alloy layer is within a range of 0.3 µm-1 µm. In some embodiments, the thickness of the alloy layer may be within a range of 0.3 µm-0.7 µm, a range of 0.7 µm-1 µm, etc. For example, the thickness of the alloy layer may be 0.3 µm, 0.7 µm, 1 µm, etc.

In practical scenarios, a thickness of the coating obtained via the PVD is typically controlled to be within a range of 0.1 µm-15 µm (e.g., 0.1 µm, 7 µm, 15 µm, etc.) or a range of 15 µm-20 µm (e.g., 15 µm, 18 µm, 20 µm, etc.), with an industrial standard primarily being within a range of 0.3 µm-5 µm (e.g., 0.3 µm, 2 µm, 5 µm, etc.).

In some embodiments, the thickness of the alloy layer may be controlled to be within a range of 0.2 µm-2 µm through the PVD. In some embodiments, the thickness of the alloy layer may be within a range of 0.2 µm-1 µm, a range of 1 µm-2 µm, etc. For example, the thickness of the alloy layer may be 0.2 µm, 1 µm, 2 µm, etc. In some cases, the thickness of the alloy layer may be further controlled to be within a range of 0.3 µm-1 µm. For example, the thickness of the alloy layer may be 0.3 µm, 0.6 µm, 1 µm, etc. However, it should be noted that a thin alloy layer may lead to a slight decrease in the antisticking performance.

By choosing an appropriate PVD, the composition of the alloy layer, the thickness of the alloy layer, and a microstructure of the alloy layer can be precisely controlled, so that the alloy layer has excellent surface properties.

As another example, the plasma spraying (also referred to as a direct plasma spraying, a plasma spray-melting technology) includes: heating the low surface energy alloy material to a molten state or a semi-molten state using a plasma flame stream, and spraying the molten powder or particles onto the substrate predetermined surface via a high-speed gas flow and then rapidly solidifying, thereby forming the alloy layer.

Using a rigid non-transferred plasma arc as a heat source, the low surface energy alloy material is heated to the molten state or the semi-molten state, atomized by a high-speed flame flow, and accelerated to be sprayed onto the substrate predetermined surface to form a robust alloy layer (also referred to as a spray coating). The alloy layer exhibits a high thermal conductivity and accumulates a large number of dispersedly distributed nanoparticles. This composite structure enables adjustment of the alloy layer and enhances a vibration resistance and a thermal shock resistance of the alloy layer.

When applying the plasma spraying to coat the cookware, gases such as argon, nitrogen, carbon dioxide are employed as the protective atmosphere.

As another example, the supersonic spraying includes: melting the low surface energy alloy material via a supersonic flame and accelerating it to a high-speed state, causing the molten powders or the particles to impact the substrate predetermined surface, thereby forming the alloy layer.

In some embodiments, the forming the alloy layer by applying the low surface energy alloy material onto the substrate predetermined surface through the plasma spraying or the supersonic spraying, includes: forming the alloy layer by spraying a powder with a particle size within a range of 1 µm-100 µm.

In some embodiments, the particle size of the powder is within a range of 1 µm-50 µm, a range of 50 µm-100 µm, etc. For example, the particle size of the powder may be 1 µm, 50 µm, 100 µm, etc. The particle size of the powder may be set according to practical needs.

The formation process of the alloy layer includes: mixing fuel (gaseous/liquid) with high-pressure oxygen in a combustion chamber for combustion to generate a supersonic flame flow (with a velocity of 300 m/s-1000 m/s), and powder particles in molten/semi-molten state impact the workpiece at a high speed, with a flame temperature of 2500°C-3000°C or higher.

In some embodiments, the particle size of the powder may be within a range of 3 µm-50 µm. In some embodiments, the particle size of the powder may also be within a range of 3 µm-20 µm, a range of 20 µm-50 µm, etc. For example, the particle size of the powder may be 3 µm, 20 µm, 50 µm, etc.

By optimizing the particle size of the powder, the melting of the powder is more uniform and sufficient during the spraying process, and the flight characteristics are more stable, which further improves the compactness of the alloy layer and reduces the porosity.

By adopting the powder with the particle size of 1 µm-100 µm and utilizing the plasma spraying or the supersonic spraying, the alloy layer is formed on the substrate predetermined surface, which helps to enhance the homogeneity, the densification, and the bonding strength of the coating.

By adopting a plurality of ways to form the alloy layer, it can be flexibly adapted to a variety of substrates and shapes of the substrate predetermined surface and suitable for a wide range of industrial scenarios, increasing the universality of the alloy layer application. Additionally, it enhances the corrosion resistance, the wear resistance, and the anti-fouling performance of the substrate predetermined surface, etc.

In some embodiments, the low surface energy alloy material possesses a wide range of applications in fields such as the marine engineering, the ship component, the ice/snow sports, and the cookware (e.g., metal cookware). The following embodiments are illustrated exemplarily in the field of the cookware.

In the field of the cookware manufacturing, the alloy layer is formed on the substrate predetermined surface, which not only preserves a thermal conductivity of the substrate, but also imparts a durable non-stickiness property to the substrate predetermined surface, thereby providing a novel technical approach for developing coating-free healthy kitchenware.

In some embodiments, when the substrate predetermined surface is the predetermined surface of the cookware, the thickness of the alloy layer is within a range of 0.2 µm-200 µm.

In some embodiments, the thickness of the alloy layer may also be within a range of 0.2 µm-100 µm, a range of 100 µm-200 µm, etc. For example, the thickness of the alloy layer may be 0.2 µm, 100 µm, 200 µm, etc.

When the substrate predetermined surface is the predetermined surface of the cookware, by setting the thickness of the alloy layer to be within the range of 0.2 µm-200 µm, it ensures the predetermined surface of the cookware to have the non-stickiness property, the easy-cleaning performance, and the corrosion resistance, while preventing a thermal conductivity reduction and a cost increase caused by an excessive thickness of the alloy layer.

In some embodiments, when the substrate predetermined surface is the predetermined surface of the cookware, the thickness of the alloy layer formed on the substrate predetermined surface via the PVD is within a range of 0.2 µm-20 µm; or the thickness of the alloy layer formed on the substrate predetermined surface via the electroplating deposition or the plasma spraying is within a range of 10 µm-500 µm.

In some embodiments, the thickness of the alloy layer formed on the substrate predetermined surface via the PVD may be within a range of 0.2 µm-10 µm, a range of 10 µm-20 µm, etc. For example, the thickness of the alloy layer may be 0.2 µm, 10 µm, 20 µm, etc.

In some embodiments, the thickness of the alloy layer formed on the substrate predetermined surface via the electroplating deposition or the plasma spraying may be within a range of 10 µm-200 µm, a range of 200 µm-500 µm, etc. For example, the thickness of the alloy layer may be 10 µm, 200 µm, 500 µm, etc. In some embodiments, the thickness of the alloy layer formed on the substrate predetermined surface via the electroplating deposition or the plasma spraying is within a range of 15 µm-200 µm.

In some embodiments, the thickness of the alloy layer formed on the substrate predetermined surface via the electroplating deposition or the plasma spraying may be within a range of 15 µm-100 µm, a range of 100 µm-200 µm, etc. For example, the thickness of the alloy layer may be 15 µm, 100 µm, 200 µm, etc.

When the substrate predetermined surface is the predetermined surface of the cookware, by controlling the thickness of the alloy layer to be within the range of 15 µm-200 µm, it ensures the alloy layer with a sufficient thickness to provide the non-stickiness property, the corrosion resistance, and the wear resistance, while avoiding a negative impact on the thermal conductivity of the cookware caused by the excessive thickness of the alloy layer.

When the substrate predetermined surface is the predetermined surface of the cookware, by setting different thickness ranges of the alloy layer based on different preparation manners of the alloy layer, it can better balance the thermal conductivity, the non-stick performance, the corrosion resistance, and the manufacturing cost.

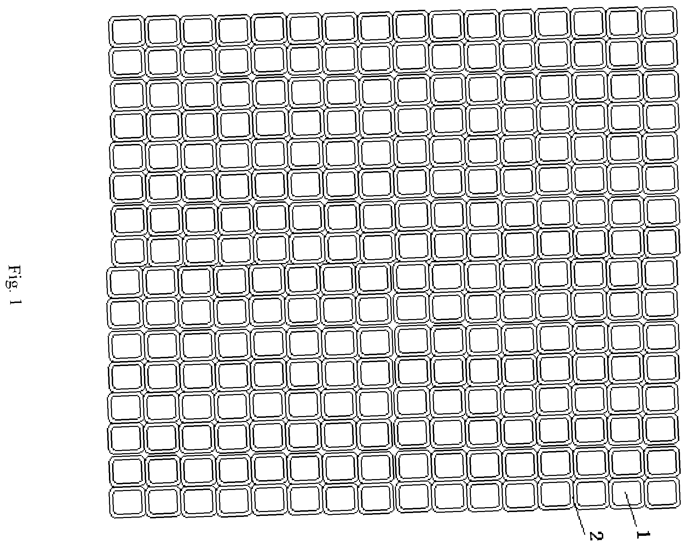

FIG. 1 is a schematic diagram illustrating arrangement and distribution of rectangular concave holes in a cookware according to some embodiments of the present disclosure.

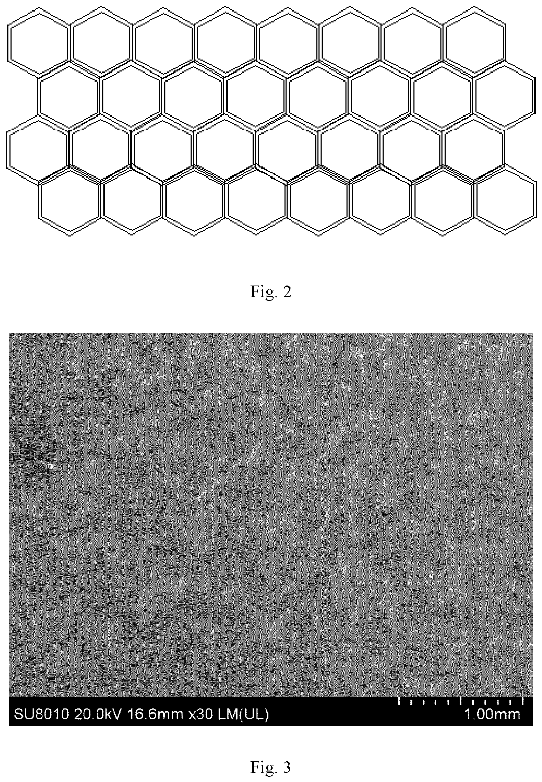

FIG. 2 is a schematic diagram illustrating arrangement and distribution of hexagonal concave holes in a cookware according to some embodiments of the present disclosure.

FIG. 3 is a scanning electron microscope (SEM) image of a cookware according to some embodiments of the present disclosure.

In some embodiments, when the substrate predetermined surface is the predetermined surface of the cookware, the substrate predetermined surface is provided with concave holes, a maximum inner dimension of each concave hole is within a range of 0.3 mm-1.2 mm; a rib width between adjacent concave holes is within a range of 0.1 mm-0.6 mm; the alloy layer covers the concave holes; the concave holes are arranged in a parallel array or a staggered array; and a depth of each concave hole is within a range of 0.2 mm-0.5 mm.

In some embodiments, the SEM image of the cookware may be shown in FIG. 3.

The concave hole refers to a recessed structure formed on the substrate predetermined surface (e.g., a surface of the cookware in contact with food) by mechanical pressing, etching, or laser processing. The concave holes and the covered alloy layer synergistically form a nano-micro composite structure, which stores oil/water through capillary action and reduces food contact area.

In some embodiments, the predetermined surface of the cookware is provided with uniformly distributed concave holes. The distribution of the concave holes may be shown in FIGs.1 and 2.

A shape of the concave hole may be set according to practical needs. For example, the shape of the concave hole includes an oval, a polygonal, etc.

In some embodiments, a longitudinal cross-section of a polygonal concave hole may be wavy.

In some embodiments, a plurality of ways may be employed to prepare the concave hole. The following describes the preparation of the polygonal concave hole as an example: an alloy mold with uniform polygonal hole protrusion molds is used to press the predetermined surface of the cookware (e.g., a stainless steel cookware surface) to form the polygonal concave holes. The uniform polygonal hole protrusion molds may also be prepared by electrochemical manners.

The polygonal (e.g., triangular, rectangular, square, pentagonal, hexagonal, octagonal, etc.) concave holes and nanoscale concave holes may be prepared by plate-making corrosion or mold engraving manners. The nanoscale concave holes are formed by pressing abrasives (dry or slurry), with a particle size of the abrasives of 30 nm-300 nm (or 500 nm).

The abrasives refer to materials used to form the nanoscale concave holes by pressing on the substrate predetermined surface. The particle size of the abrasives refers to a particle diameter range of hard particles used for preparing the nanoscale concave holes.

In some embodiments, the particle size of the abrasives may be within a range of 30 nm-100 nm, a range of 100 nm-300 nm, a range of 300 nm-500 nm, etc. For example, the particle size of the abrasives may be 30 nm, 100 nm, 300 nm, 500 nm, etc.

Better nitriding of the predetermined surface of the cookware may be achieved by setting up the concave holes of nanometer size.

The maximum inner dimension refers to a maximum geometric span of the concave hole. For example, when the shape of the concave hole is the oval, the maximum inner dimension is a distance of a long axis of the concave hole. For example, when the shape of the concave hole is the polygon, the maximum inner dimension is a distance of the diagonal.

In some embodiments, the maximum inner dimension of the concave hole may also be within a range of 0.3 mm-1 mm, a range of 1 mm-1.2 mm, etc. For example, the maximum inner dimension is 0.3 mm, 1 mm, 1.2 mm, etc.

In some embodiments, the rib width between the adjacent concave holes may also be within a range of 0.1 mm-0.3 mm, a range of 0.3 mm-0.6 mm, etc. For example, the rib width is 0.1 mm, 0.3 mm, 0.6 mm, etc.

In some embodiments, by reasonably designing the rib width between the adjacent concave holes, it can cause that the rib width is smaller than an area of the concave hole, reducing a machining accuracy requirement. For example, the rib width between the adjacent concave holes is optimized to be within a range of 0.3 mm-0.5 mm. For example, the rib width is 0.3 mm, 0.4 mm, 0.5 mm, etc.

In some embodiments, the depth of each concave hole may also be within a range of 0.2 mm-0.3 mm, a range of 0.3 mm-0.5 mm, etc. For example, the depth of each concave hole is 0.2 mm, 0.3 mm, 0.5 mm, etc.

In some embodiments, by optimizing the depth of each concave hole to be within a range of 0.3 mm-0.4 mm, it contributes to effects such as enhancing the oil storage capacity and ensuring the continuity of the oil film. For example, the depth of each concave hole is 0.3 mm, 0.35 mm, 0.4 mm, etc.

By providing the concave holes on the substrate predetermined surface, the mechanical interlocking property of the predetermined surface of the cookware is enhanced, effectively preventing the alloy layer from peeling or falling off during use. Meanwhile, the concave holes are designed in the parallel array or the staggered array, which makes the predetermined surface of the cookware form a micro-nano composite structure, so that the surface of the cookware has a better the non-stickiness property and the easy cleaning property.

In some embodiments, the alloy layer prepared by the foregoing manner is applied to the alloy layer micro-nano structured polygonal concave hole non-stick cookware. The cookware includes a metal cookware body and the contact surface of the metal cookware body with food (e.g., the surface of the stainless steel layer, etc.) is provided with uniformly distributed polygonal concave holes. The polygonal concave holes are arranged in the parallel array or a radial (radiation) array. If the contact surface is divided into a number of small areas, the polygonal concave holes on each small area are arranged in the parallel array. The area of each small area may be within a range of 20 cm²-100 cm². For example, the area of each small area is 20 cm², 60 cm², 100 cm², etc. If the contact surface is not divided into the small areas, the polygonal concave holes may be of a concentric circle structure or a radial (radiation) structure.

In some embodiments, the rib width between adjacent polygonal concave holes may also be 300 µm, 400 µm, or 500 µm. The polygonal concave holes are formed by pressing through a carbide mold under a pressure apparatus, causing the polygonal concave holes to form a hardened layer structure with the cookware body. In addition, uniformly distributed convex rib molds prepared from carbide are used to press on the cookware body plate, thereby achieving uniform distribution of the polygonal concave holes on the cookware body.

In some embodiments, the maximum dimension (e.g., a height difference) between the highest point of the protrusion between the adjacent polygonal concave holes and the lowest point of the concave arcs of the polygonal concave holes does not exceed 500 µm.

A total area of the polygonal concave holes accounts for a large proportion of an area of the contact surface between the entire metal cookware body and the food, usually exceeding 50%. This design ensures both physical non-stick performance of the cookware and guarantees its service life.

The cookware body surface (i.e., a contact surface of the cookware with the food) is typically made of 304 stainless steel or made of a steel-aluminum composite or a steel-aluminum-steel composite (referred to as tri-ply steel, aiming to reduce weight and achieving uniform temperature conduction). In some embodiments, 316 stainless steel may also be used for the cookware body surface, which may also be applied to iron cookware or other cookware.

In some embodiments, a wavy upper convex arc (a raised rib between the adjacent polygonal concave holes, i.e., the polygonal frame) is narrower than a lower concave arc (i.e., the polygonal concave hole itself). That is, the area of the polygonal frame is less than the area of the polygonal concave hole.

In some embodiments, a manner of preparing a non-stickiness cookware using a coated metal includes: using a stainless steel or iron cookware (also referred to as the metal cookware body) as the substrate, and selectively compounding an aluminum layer as a heat-evenly-distributing layer. The alloy layer is formed by spraying the low surface energy alloy material on the predetermined surface of the cookware via the plasma spraying. As shown in FIGs. 1 and 2, the predetermined surface of the treated cookware is provided with the polygonal concave holes (labeled as 1) that are uniformly distributed and of uniform depth, a distribution density of the concave holes in the bottom area of the cookware is denser than that in the edge region, and the adjacent polygonal concave holes are spaced apart from each other by raised structures (labeled as 2).

In some embodiments, the treatment of the cookware includes: performing a clean pretreatment on the cookware, and then forming the alloy layer on the predetermined surface of the cookware by the aforementioned preparation process.

For example, when employing the PVD as the preparation process, polishing treatment may be performed on the cookware.

As another example, when employing the plasma spraying as the preparation process, the cookware needs to undergo sandblasting (surface treatment with coarse sand to increase surface roughness) or shot peening treatment; subsequently, a non-transferred plasma arc is utilized as the heat source to spray the cleaned cookware. For example, the low surface energy alloy material is heated to the molten state or the semi-molten state, atomized via the high-speed flame flow, and accelerated to be sprayed onto the pretreated cookware, forming a robust porous-structured alloy spray coating. The powder forming the alloy layer may be spherical powder.

In some embodiments, a preparation manner of the low surface energy alloy material includes: melting the Co and other alloy elements in a vacuum induction furnace according to a weight ratio of each component specified in the composition examples. During the preparation process of the low surface energy alloy material, a vacuum induction melting may be employed. Additionally, the vacuum induction melting may be combined with a vacuum consumable furnace or an electroslag furnace remelting. After composition melting, the low surface energy alloy material is dispersed into powder under an inert gas protective atmosphere. The preparation manner is referenced to melting of Ni-Cr alloys, i.e., Ni-Cr heat resistant alloys.

The Co content is within a range of 85-99.9 parts by weight, and the Cr content, the Cu content, the Ni content, the Mn content, the Ti content, the Si content, or/and the Fe content is within a range of 0.01-15 parts by weight. In the present disclosure, the predetermined surface of the cookware is primarily composed of the alloying material, which is formed by combining Co as the main component with Cr, Ni, Cu, Mn, Ti, Si, or/and Fe. The non-stickiness cookware with a low surface energy Co and Co alloy material layer is formed after the cookware is coated via the plasma spraying. Pure cobalt, with a Co content of 99% or higher, also falls within the protection scope of the present disclosure. During the electrolytic Co production process, impurity elements such as Ni, Cu, and Mn, Fe, Cr, and Si are generated, and contents of the impurity elements are generally within a range of 0.01-0.04%. The Cr content, the Ti content, and the Si content are even less.

Alloy composition example 1: the Co content was 40 parts by weight, the Cr content was 20 parts by weight, the Mo content was 5 parts by weight, and the Ni content was 1 part by weight. When forming the alloy layer on the predetermined surface of the cookware via the plasma spraying, a mixed gas of argon gas (Ar) and hydrogen gas (H₂) at a volume ratio of 1:1 was used as the protective atmosphere. The volume ratio of the Ar and the H₂ may be set according to practical needs. Test results demonstrate that the low surface energy alloy material prepared according to the formulation of the alloy composition example 1, when applied to the cookware, enables the cookware to achieve Grade I non-stick performance.

Alloy composition example 2: the Co content was 50 parts by weight, the Cr content was 18 parts by weight, the Mo content was 5 parts by weight, and the Ni content was 5 parts by weight. The Ar was used as the protective atmosphere when spraying the cookware via the plasma spraying.

Alloy composition example 3: the Co content was 58 parts by weight, the Cr content was 18 parts by weight, the Mo content was 5 parts by weight, and the Ni content was 5 parts by weight. The Ar was used as the protective atmosphere when spraying the cookware via the plasma spraying.

Alloy composition example 4: the Co content was 62 parts by weight, the Cr content was 20 parts by weight, the Mo content was 3 parts by weight, and the Ni content was 1 part by weight. The Ar and the H₂ were used as the protective atmosphere when spraying the cookware via the plasma spraying.

Alloy composition example 5: the Co content was 69 parts by weight, the Cr content was 20 parts by weight, the Mo content was 2 parts by weight, and the Ni content was 3 parts by weight. The Ar was used as the protective atmosphere when spraying the cookware via the plasma spraying.

Alloy composition example 6: the Co content was 75 parts by weight, the Cr content was 17 parts by weight, the Mo content was 3 parts by weight, and the Ni content was 3 parts by weight. A carbon dioxide (CO₂) was used as the protective atmosphere when spraying the cookware via the plasma spraying.

Alloy composition example 7: the Co content was 80 parts by weight, the Cr content was 14 parts by weight, the Mo content was 2 parts by weight, and the Ni content was 2 parts by weight. The CO₂ was used as the protective atmosphere when spraying the cookware via the plasma spraying.

Alloy composition example 8: the Co content was 85 parts by weight, the Cr content was 8 parts by weight, the Mo content was 2 parts by weight, and the Ni content was 4 parts by weight. The Ar and the H₂ were used as the protective atmosphere when spraying the cookware via the plasma spraying or the supersonic spraying.

Alloy composition example 9: the Co content was 90 parts by weight, the Cr content was 7 parts by weight, the Mo content was 0.2 parts by weight, and the Ni content was 1 part by weight. The CO₂ was used as the protective atmosphere when spraying the cookware via the plasma spraying or the supersonic spraying.

Alloy composition example 10: the Co content was 95 parts by weight, the Cr content was 3 parts by weight, the Mo content was 0.2 parts by weight, and the Ni content was 1 part by weight. The CO₂ was used as the protective atmosphere when spraying the cookware via the plasma spraying or the supersonic spraying.

Co (base) and alloy composition example 11: the Co content was 99.9 parts by weight, each of the Fe content, the Ni content, the Cu content, the Mn content or/and the Cr content was within a range of 0.01-0.1 parts by weight. Fe, Ni, Cu, Mn and/or Cr exist as the impurities during the electrolytic Co production process.

Based on electrolytic Co, small amounts of the Cr and the Mo were added, both the Cr content and the Mo content are controlled to be within a range of 0.1-0.5 parts by weight, along with an addition of 0.1-0.5 parts by weight of Ni. The mixed gas of the Ar and the H₂ at the volume ratio of 1:1 was used as the protective atmosphere when spraying the cookware via the plasma spraying or the supersonic spraying. Test results demonstrate that the low surface energy alloy material prepared according to the above formulation, when applied to cookware, achieves 100% non-stickiness effectiveness, reaching the non-stick performance level of Teflon^{®}-coated cookware.

Alloy composition example 12: the Co content was 95 parts by weight, the Cr content was 1 part by weight, the Mo content was 3 parts by weight, and the Ni content was 1 part by weight, and at least two of Mn, Ni, and Fe was added at 0.5 parts by weight. The Ar was used as the protective atmosphere when spraying the cookware via the plasma spraying or the supersonic spraying. Test results demonstrate that the low surface energy alloy material prepared based on the formulation of the alloy composition example 12, when applied to the cookware, achieves 95% non-stickiness effectiveness.

Alloy composition example 13: the Co content was 93 parts by weight, and the Ni content, the Mn content, the Cr content, or the Fe content were all 5 parts by weight. The Ar was used as the protective atmosphere when spraying the cookware via the plasma spraying. Test results demonstrate that the low surface energy alloy material prepared based on the formulation of the alloy composition example 13, when applied to the cookware, achieves 93% non-stickiness effectiveness.

Alloy composition example 14: the Co content was 90 parts by weight, and the Ni content, the Mn content, the Cr content, or the Fe content were all 5 parts by weight. The Ar was used as the protective atmosphere when spraying the cookware via the plasma spraying. Test results demonstrate that the low surface energy alloy material prepared based on the formulation of the alloy composition example 14, when applied to the cookware, achieves 90% non-stickiness effectiveness.

Alloy composition example 15: the Co content was 89 parts by weight, and the Cr content, the Ni content, the Mo content, the Mn content, the Ti content, or the Fe content were 2 parts by weight. The Ar was used as the protective atmosphere when spraying the cookware via the plasma spraying. Test results demonstrate that the low surface energy alloy material prepared based on the formulation of the alloy composition example 15, when applied to the cookware, achieves 85% non-stickiness effectiveness.

Alloy composition example 16: the Co content was 85 parts by weight, and at least two to three of Cr, Ni, Mo, Mn, Ti, or Fe was added at 4 parts by weight. The CO₂ was used as the protective atmosphere when spraying the cookware via the plasma spraying. Test results demonstrate that the low surface energy alloy material prepared based on the formulation of the alloy composition example 16, when applied to the cookware, achieves 80% non-stickiness effectiveness.

Alloy composition example 17: the Co content was 98 parts by weight, and at least two to three of Cr, Mn, Ti, and Fe was added at 5 parts by weight; the Mo content was 8 parts by weight; and the Ni content was 2 parts by weight. The CO₂ was used as the protective atmosphere when spraying the cookware via the plasma spraying. Test results demonstrate that the low surface energy alloy material prepared based on the formulation of the alloy composition example 17, when applied to the cookware, achieves 95% non-stickiness effectiveness.

Alloy composition example 18: the Co content was 96 parts by weight, the Cr content was 8 parts by weight, and the Fe content was 4 parts by weight. The mixed gas of Ar and H₂ was used as the protective atmosphere when spraying the cookware via the plasma spraying. Test results demonstrate that the low surface energy alloy material prepared based on the formulation of the alloy composition example 18, when applied to the cookware, achieves 93% non-stickiness effectiveness.

Alloy composition Example 19: the Co content was 93 parts by weight, the Cr content was 12 parts by weight, the Mo content was 6 parts by weight, and the Ni content was 8 parts by weight. The CO₂ was used as the protective atmosphere when spraying the cookware via the plasma spraying. Test results demonstrate that the low surface energy alloy material prepared based on the formulation of the alloy composition example 19, when applied to the cookware, achieves 93% non-stickiness effectiveness.

Alloy composition example 20: the Co content was 85 parts by weight, the Cr content was 15 parts by weight, the Mo content was 6 parts by weight, and the Ni content was 1 part by weight. The CO₂ was used as the protective atmosphere when spraying the cookware via the plasma spraying. Test results demonstrate that the low surface energy alloy material prepared based on the formulation of the alloy composition example 20, when applied to the cookware, achieves 70% non-stickiness effectiveness.

In the alloy composition examples 11-15: 0.4 parts by weight of Si or 0.4 parts by weight of Ti, or 1 part by weight of the Si or 1 part by weight of the Ti was further added. The cookware achieves a similar non-stickiness effectiveness.

In alloy composition examples 16-20: Si and Ti were added, for example, the Si content or the Ti content was 0.8 parts by weight, for another example, the Si content or the Ti content was 2 parts by weight. The addition of Si and Ti makes non-stickiness effectiveness better. When the Si content is 1 part by weight and the Fe content is 2.5 parts by weight, it is characterized that the Fe content is basically the same as the Si content.

One of the cores of the present disclosure is that an area for holding food (a raised part) accounts for only 30%-50% of a total area of the pot body (a bottom of the pot), such as 30%-45%. It has a very good anti-stick performance. After the cookware is sprayed via the plasma spraying, the surface of the cookware may then be treated by sanding (grinding), polishing, etc., to reduce the roughness of the inside surface of the cookware and reduce the friction between the food and the inside surface of the cookware, making the spatula to move smoother when stir-frying, and achieving the non-stickiness effectiveness comparable to that of the PTFE Teflon coating. Additionally, it can reduce a manufacturing cost, which is only half of that of other functional non-stickiness cookware.

The finished alloy layer in the present disclosure needs to be treated via the plasma spraying and the supersonic spraying, and then sanded (ground) and polished.

The cookware body plate is in the shape of a concave cookware, which is formed by pressing a flat plate with a hydraulic press equipment. The cookware body is attached to a cookware handle. The back of the stainless steel is compounded with an aluminum layer. When using a composite material to make the cookware body, a thickness of the stainless steel is within a range of 0.5 mm-1 mm. For example, the thickness of the stainless steel is 0.5 mm, 0.7 mm, 1 mm, etc. A thickness of the aluminum layer is around 1.5 mm. The compounding method may include pressing or explosive compounding of the stainless steel or titanium materials with aluminum plates.

The solution of the present disclosure is applicable not only to various cooking cookware but also to scenarios such as an electric griddle and a rice cooker.

For example, an application of the electric griddle includes: the electric griddle with a polygonal concave hole non-stickiness layer with a nano-microstructure of the alloy layer, including an upper heating plate, a lower heating plate, a cookware body surface, and a heating assembly. The heating assembly is disposed inside the cookware body surface of the upper heating plate or/and the lower heating plate, and the upper heating plate and the lower heating plate are mounted on the upper cover and a base, respectively. The structure of the cookware body surface includes uniformly distributed protrusions on the lower surface of the upper heating plate and the upper surface of the lower heating plate. The surfaces of the upper and lower heating plates are made of stainless steel or a composite metal material of aluminum. The part of the cookware surface in contact with food part is the polygonal concave hole non-stickiness layer with the nano-microstructure of the alloy layer.

The present disclosure focuses on Co and Co-based alloy materials with extremely low surface energy, the low surface energy alloy materials have a wide range of application in a plurality of fields, in particular the cookware, the marine engineering, the ships, the ice/snow sports, etc. Existing low surface energy alloy materials are organic materials. Although the organic materials have good weather resistance, lubrication property, and an environmental friendliness, with advancement of the marine engineering and the ship industry, a demand for the low surface energy alloy material has grown year by year, presenting significant market application prospects. However, the organic materials have a low service temperature. Therefore, the low surface energy alloy materials need to have a higher service temperature, which may be more than 400°C.

When applied to the cookware, a large number of dispersedly distributed nanoparticle hole arrays (i.e., the concave holes) may be accumulated by covering the alloy layer on the surface of the metal such as stainless steel via the plasma spraying. The setting of the concave holes may make the contact area between the food and the cookware body change. The concave holes contain oil and water, which reduces the heat that is directly transferred to the food from the cookware body and avoids the food from sticking because of the high temperature. The micro-nano structure of the alloy layer formed by the plasma spraying is superior to that produced by the PVD. Additionally, it exhibits good biocompatibility and is harmless to the human body.

The polygonal concave holes exhibit better performance compared to circular concave holes. An area of the polygonal concave holes is larger than that of the circular holes, which can constrain the amount of oil and water in the cookware and be constrained by the surface tension, realizing good non-stickiness effect, which is comparable to that of the existing fluorine-coated non-stickiness material. The inner surface of the stainless steel metal cookware body does not need an additional non-stickiness film layer, keeping the original effect of stainless steel and the spraying. Even if high-temperature stir-frying is performed or the cookware is empty-heated, there is no release of toxic substances and gases, ensuring no pollution to the cooked food or the kitchen environment, and making cooking safer.

The cookware with nanoscale holes absorbs air and grease during actual use. Hot air and grease mist are generated during the heating process to hold up the food, resulting in better performance. The villous effect formed by the mammillary protrusion structure reduces the friction between the food and the inner surface of the cookware body. Without the need for additional chemical coatings, it achieves the effect of non-stickiness by physical means, which makes the consumer cooking food healthier. It can withstand a metal spatula when using and can be cleaned with a metal brush when cleaning. Non-stick performance reaches the grade I non-stick (capable of continuously frying more than 100 eggs without sticking in the absence of oil or with minimal grease). It works better when applied via the plasma spraying or the supersonic spraying.

While embodiments of the present disclosure have been shown and described above, it is to be understood that the foregoing embodiments are exemplary and are not to be construed as limiting the present disclosure. Those of ordinary skill in the art can make changes, modifications, substitutions, and variations to the above embodiments within the scope of the disclosure without departing from its principles and purposes.

## Claims

1. A low surface energy alloy material, wherein a composition of the low surface energy alloy material comprises at least two of Co, Fe, Ni, Cu, Mn, or Cr, wherein a Co content is within a range of 40-99.9 parts by weight, and each of a Fe content, a Ni content, a Cu content, a Mn content, and a Cr content is within a range of 0.01-20 parts by weight.

2. The low surface energy alloy material of claim 1, wherein the composition of the low surface energy alloy material further comprises Mo, wherein the Cr content is within a range of 0.5-8 parts by weight, and a Mo content is within a range of 0.5-8 parts by weight.

3. The low surface energy alloy material of claim 1, wherein the composition of the low surface energy alloy material further comprises Mo, wherein the Co content is within a range of 85-99.9 parts by weight, the Cr content is within a range of 0.1-15 parts by weight, a Mo content is within a range of 0.5-5 parts by weight, and the Ni content is within a range of 0.5-5 parts by weight.

4. The low surface energy alloy material of claim 1, wherein the composition of the low surface energy alloy material further comprises Ti and Si, wherein at least one of a Ti content and a Si content is within a range of 0.5-15 parts by weight.

5. The low surface energy alloy material of claim 1, wherein the composition of the low surface energy alloy material further comprises Ti and Mo, wherein the Co content is within a range of 40-80 parts by weight, the Cr content is within a range of 7-20 parts by weight, a Mo content is not greater than 8 parts by weight, the Ni content is within a range of 1-8 parts by weight, and at least one of the Mn content and a Ti content is within a range of 0.5-15 parts by weight.

6. A method for treating a substrate predetermined surface, wherein the method comprises:
forming an alloy layer on the substrate predetermined surface by applying the low surface energy alloy material of claim 1 onto the substrate predetermined surface via electroplating deposition, physical vapor deposition (PVD), plasma spraying, or supersonic spraying; wherein
the substrate predetermined surface includes at least one of a predetermined surface of marine engineering equipment, a predetermined surface of a ship component, a predetermined surface of ice/snow sports equipment, a predetermined surface of cookware; and
a thickness of the alloy layer is within a range of 0.2 µm-500 µm.

7. The method of claim 6, wherein the forming the alloy layer by applying the low surface energy alloy material onto the substrate predetermined surface via the plasma spraying or the supersonic spraying, includes:
forming the alloy layer by spraying a powder with a particle size within a range of 1 µm-100 µm.

8. The method of claim 7, wherein a particle size of the powder is within a range of 3 µm-50 µm.

9. The method of claim 6, wherein when the substrate predetermined surface is the predetermined surface of the cookware, the thickness of the alloy layer is within a range of 0.2 µm-200 µm.

10. The method of claim 6, wherein when the substrate predetermined surface is the predetermined surface of the cookware,
the thickness of the alloy layer formed via the PVD is within a range of 0.2 µm-20 µm; or
the thickness of the alloy layer formed via the electroplating deposition or the plasma spraying is within a range of 10 µm-500 µm.

11. The method of claim 10, wherein the thickness of the alloy layer formed via the electroplating deposition or the plasma spraying is within a range of 15 µm-200 µm.

12. The method of claim 9, wherein the PVD includes vacuum evaporation coating, vacuum sputtering coating, or vacuum ion coating.

13. A substrate predetermined surface treated by the method of claim 6, wherein when the substrate predetermined surface is the surface of the cookware, the substrate predetermined surface is provided with concave holes, wherein
a maximum inner dimension of each concave hole is within a range of 0.3 mm-1.2 mm;
a rib width between adjacent concave holes is within a range of 0.1 mm-0.6 mm;
the alloy layer covers the concave holes;
the concave holes are arranged in a parallel array or a staggered array; and
a depth of each concave hole is within a range of 0.2 mm-0.5 mm.
